# EUROPEAN PATENT APPLICATION

(11) **EP 4 760 295 A1**
(43) Date of publication of application: **17.06.2026**
(21) Application number: 25857179.3
(22) Date of filing: 09.07.2025
(51) Int. Cl.: G01R 31/367, G01R 31/36, G01R 31/396, G01R 31/385, G06N 20/00

(54) **DEVICE AND METHOD FOR PREDICTING BATTERY CAPACITY**

(30) Priority: 20.08.2024 KR 20240111012
(71) Applicant: LG Energy Solution, Ltd., Seoul 07335 (KR)
(72) Inventor: YANG, Jieung, Daejeon 34122 (KR); KWON, Hyun Cheol, Daejeon 34122 (KR)
(74) Representative: Goddar, Heinz J.
(86) International application number: PCT/KR2025/009935
(87) International publication number: WO 2026/043092

(57) **Abstract**

A device for predicting a battery capacity, according to one embodiment of the present invention, may comprise: at least one processor; and a memory for storing at least one instruction executed using the at least one processor. The at least one instruction can include the instructions of: collecting formation process data including a state value for respective batteries measured during a battery formation process; calculating a plurality of predefined statistical values by using the formation process data; and inputting the statistical values to a pre-trained prediction model, and predicting a battery capacity at a specific temperature by using a prediction value output by the prediction model.

## Description

### [Technical Field]

This application claims priority to and the benefit of Korean Patent Application No.10-2024-0111012 filed in the Korean Intellectual Property Office on August 20, 2024 the entire contents of which are incorporated herein by reference.

The present invention relates to an apparatus and method for predicting battery capacity, and more particularly, to an apparatus and method for predicting battery capacity using a machine learning based prediction model.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries, capable of recharging and reuse, may be used as an energy source for small devices such as mobile phones, tablet PCs and vacuum cleaners, and also used as an energy source for medium and large devices such as personal mobility, automobiles and an energy storage system (ESS) for smart grids.

Battery cells are manufactured through assembly and activation processes. Because battery cells are assembled in a discharged state, the activation process after the assembly process activates positive electrode active material and forms a solid electrolyte interface (SEI) on the negative electrode, enabling the battery to function. This activation process is also called a formation process.

The activation process may include a charge/discharge process, which involves charging and discharging the battery cells through a charge/discharge device to form an SEI, and an aging process, which involves maintaining the battery cells under specific conditions of temperature, pressure, and humidity through an aging device to stabilize the SEI.

To assess battery cell quality, performance values of each battery cell may be measured before or after the activation process. Since a comprehensive measurement of all battery cells as to battery capacity is impossible, a method is typically used to estimate battery capacity based on state values measured before and after the activation process.

Meanwhile, capacity at a specific temperature is sometimes required as a battery performance indicator. Typically, battery capacity at a specific temperature differs from the capacity determined during the activation process, making it difficult to accurately and quickly calculate this performance indicator.

Among the prior art documents relevant to the present invention, KR 10-2683336 B is of some relevance.

### [Detailed Description of the Invention]

### [Technical Problem]

To obviate one or more problems of the related art, embodiments of the present disclosure provide a battery capacity prediction apparatus that uses a machine learning-based prediction model to predict battery capacity.

To obviate one or more problems of the related art, embodiments of the present disclosure also provide a battery capacity prediction method by the battery capacity prediction apparatus.

To obviate one or more problems of the related art, embodiments of the present disclosure also provide a battery capacity prediction system including the battery capacity prediction apparatus.

### [Technical Solution]

In order to achieve the objective of the present disclosure, a battery capacity prediction apparatus may include at least one processor and a memory that stores at least one command executed by the processor.

Here, the at least one instruction may include an instruction to collect activation process data, the activation process data including state values for each of a plurality of batteries measured during a battery activation process; an instruction to calculate a plurality of predetermined statistical values using the activation process data; and an instruction to input the statistical values into a pre-trained prediction model and predict a battery capacity at a specific temperature using predicted values output by the prediction model.

The activation process data includes **one or more of** temperature data, voltage data, charge capacity data, and discharge capacity data for each of the batteries.

The instruction to calculate the plurality of statistical values may include an instruction to calculate a first quartile temperature value, an average voltage value, a first quartile voltage value, a third quartile voltage value, a sum of charge capacities, and a sum of discharge capacities using the activation process data.

The prediction model may include a plurality of base models each of which outputs a predicted value when the statistical values are input; and a metamodel that outputs a final predicted value when predicted values of each of the base models are input.

The instruction to predict the battery capacity may include an instruction to generate a data stack by stacking the predicted values when the predicted values of each of the base models are output; an instruction to input the data stack into the metamodel; and an instruction to determine the final predicted value output by the metamodel as the battery capacity at the specific temperature.

The prediction model may include one or more of a first base model based on a RandomForest (RF) algorithm, a second base model based on a Support Vector Machine (SVM) algorithm, and a third base model based on a Principal Components Regression (PCR) algorithm.

The prediction model may include any one of a first metamodel based on an RF algorithm, a second metamodel based on an SVM algorithm, and a third metamodel based on a PCR algorithm.

The metamodel may be a second metamodel based on an SVM algorithm.

According to another embodiment of the present disclosure, a battery capacity prediction method may include collecting activation process data, the activation process data including state values for each of a plurality of batteries measured during a battery activation process; calculating a plurality of predetermined statistical values using the activation process data; and inputting the statistical values into a pre-trained prediction model, and predicting a battery capacity at a specific temperature using predicted values output by the prediction model.

The activation process data may include **one or more of** temperature data, voltage data, charge capacity data, and discharge capacity data for each of the batteries.

The calculating of the plurality of statistical values may include calculating a first quartile temperature value, an average voltage value, a first quartile voltage value, a third quartile voltage value, a sum of charge capacities, and a sum of discharge capacities using the activation process data.

The prediction model may include a plurality of base models each of which outputs a predicted value when the statistical values are input; and a metamodel that outputs a final predicted value when predicted values of each of the base models are input.

The predicting of the battery capacity may include generating a data stack by stacking the predicted values when the predicted values of each of the base models are output; inputting the data stack into the metamodel; and determining the final predicted value output by the metamodel as the battery capacity at the specific temperature.

According to another embodiment of the present disclosure, a battery capacity prediction system may include a battery capacity prediction apparatus that predicts battery capacity at a specific temperature using a machine learning-based prediction model; and a prediction model generation apparatus that generates the prediction model and provides the prediction model to the battery capacity prediction apparatus.

Here, the prediction model generation apparatus uses battery activation process data to calculate a plurality of predetermined statistical values and uses the statistical values as training data to train the prediction model.

### [Advantageous Effects]

According to embodiments of the present disclosure, the battery capacity at a specific temperature can be predicted more accurately and quickly.

### [Brief Description of the Drawings]

FIG. 1 illustrates a general battery manufacturing process.
FIG. 2 is a block diagram of a battery capacity prediction system according to embodiments of the present invention.
FIG. 3 is a block diagram of a battery capacity prediction apparatus and a prediction model generation apparatus according to embodiments of the present invention.
FIG. 4 is an operational flowchart illustrating a prediction model generation method according to embodiments of the present invention.
FIG. 5 is a block diagram of a prediction model according to embodiments of the present invention.
FIG. 6 is a graph illustrating the variables applied to a prediction model according to embodiments of the present invention.
FIG. 7 is an operational flowchart of a battery capacity prediction method according to embodiments of the present invention.
FIG. 8 is a graph illustrating the prediction accuracy of a battery capacity prediction method according to embodiments of the present invention.
FIG. 9 is a block diagram of a prediction model generation apparatus according to embodiments of the present invention.
FIG. 10 is a block diagram of a battery capacity prediction apparatus according to embodiments of the present invention.

10: process equipment
20: data collection apparatus
100: battery capacity prediction system
110: battery capacity prediction apparatus
120: prediction model generation apparatus
900: prediction model generation apparatus
1000: battery capacity prediction apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

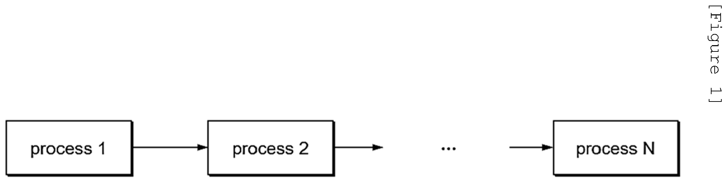

FIG. 1 illustrates a general battery manufacturing process.

Batteries may be manufactured by sequentially performing a plurality of unit processes. More specifically, the battery manufacturing process may be categorized into N unit processes, and the first through Nth processes may be sequentially performed to manufacture a battery.

For example, battery cells may be manufactured by sequentially performing unit processes classified as an electrode coating process (process 1), an electrode rolling process (process 2), an assembly process (process 3), an activation process (process 4), and an End-of-Line (EOL) process (process 5).

During an individual unit process or after battery manufacturing is completed, a performance testing may be conducted to determine whether the battery exhibits the intended performance. For example, various performance values, such as the open circuit voltage, charge/discharge voltage, charge/discharge capacity, and internal resistance of a battery cell, may be measured before or after the activation process.

For battery cell capacity (energy), a method is typically used to estimate battery capacity based on state values measured before and after the activation process, since it is impossible to conduct a comprehensive inspection of all battery cells.

Meanwhile, sometimes, upon a customer's request, capacity at a specific temperature (e.g., 40 degrees Celsius) is required as a battery performance indicator. In this case, a capacity prediction model, defined with various process factors including temperature as variables, and process data for each of these process factors may be utilized. However, if many process factors are defined as variables in the capacity prediction model to improve estimation accuracy, multicollinearity may reduce model reliability and increase system load, potentially delaying data processing time.

The present invention is presented to address these issues and proposes a technique for more accurately and quickly predicting battery capacity (energy) at a specific temperature. Hereinafter, various embodiments of the present invention will be described in detail with reference to the attached drawings.

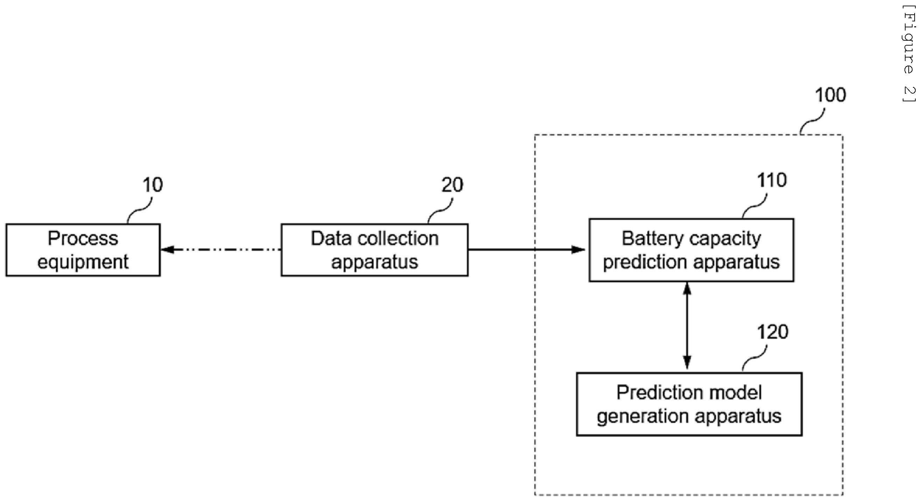

FIG. 2 is a block diagram of a battery capacity prediction system according to embodiments of the present invention.

Referring to FIG. 2, the battery capacity prediction system 100 according to embodiments of the present invention may include a battery capacity prediction apparatus 110 and a prediction model generation apparatus 120.

The battery capacity prediction system 100 may receive data generated during a battery manufacturing process from a data collection device 20 that interfaces with a process equipment 10.

The process equipment 10 may correspond to an activation process equipment and may include a charge/discharge device and an aging device.

The data collection device 20 may collect process data, including state values measured and/or calculated during and/or after the battery manufacturing process is completed. For example, the data collection device 20 may collect activation process data, including temperature data, voltage data, charge capacity data, and discharge capacity data for each of a plurality of batteries.

The data collection device 20 may provide collected process data to the battery capacity prediction system 100.

The battery capacity prediction system 100 may use the process data provided from the data collection device 20 to create a prediction model for predicting battery capacity at a specific temperature, or to predict a battery capacity at a specific temperature. For example, the prediction model generation apparatus 120 may train a predefined machine learning-based prediction model using the activation process data. Furthermore, the battery capacity prediction apparatus 110 may input the activation process data into the trained prediction model to estimate battery capacity at a specific temperature.

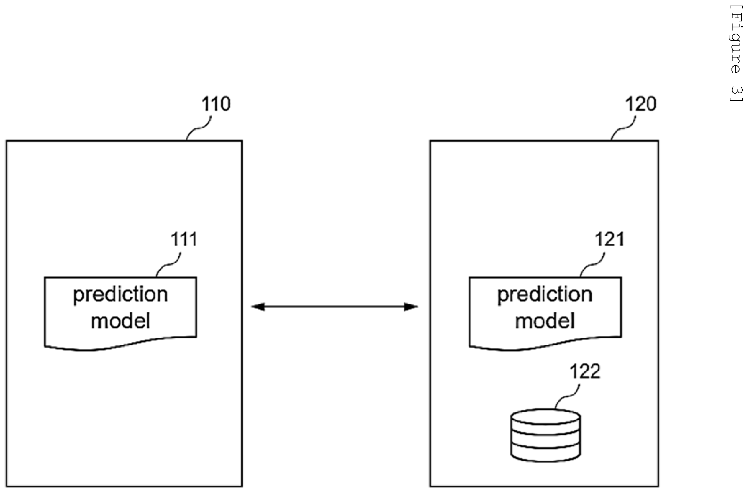

FIG. 3 is a block diagram of a battery capacity prediction apparatus and a prediction model generation apparatus according to embodiments of the present invention.

Referring to FIG. 3, the battery capacity prediction system may include a battery capacity prediction apparatus 110 and a prediction model generation apparatus 120.

The battery capacity prediction apparatus 110 may use a machine learning-based prediction model 111 to predict battery capacity at a specific temperature. Here, the battery capacity prediction apparatus 110 may receive a trained prediction model 121 from the prediction model generation apparatus 120.

The battery capacity prediction apparatus 110 may receive activation process data from the data collection device 20 of FIG. 2 and process the activation process data to generate input data to be applied to the prediction model 111. Thereafter, the battery capacity prediction apparatus 110 may supply the input data into the prediction model 111 and determine a predicted value output from the prediction model 111 as the battery capacity at a specific, predefined temperature.

The prediction model generation apparatus 120 may generate a prediction model 121 and provide the prediction model 121 to the battery capacity prediction apparatus 110.

The prediction model generation apparatus 120 may train a machine learning-based prediction model 121 using training data stored in the storage device 122. Here, the prediction model 121 may correspond to an ensemble model comprising a plurality of base models and a metamodel. Once training of the prediction model 121 is completed, the prediction model generation apparatus 120 may provide the trained prediction model 121 to the battery capacity prediction apparatus 110.

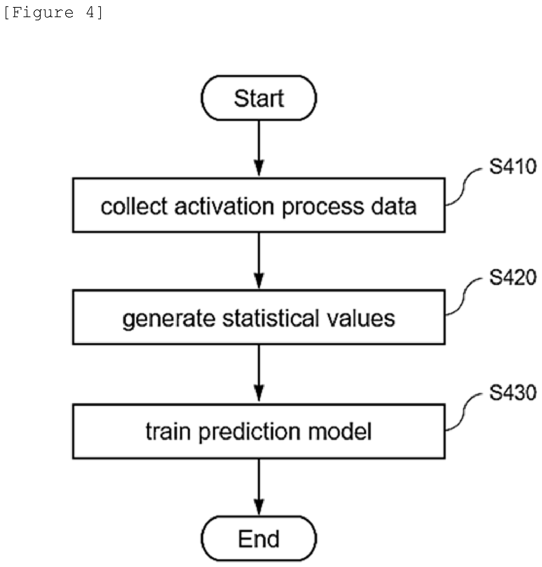

FIG. 4 is an operational flowchart illustrating a prediction model generation method according to embodiments of the present invention.

The prediction model generation apparatus may collect activation process data (S410).

The activation process data may include state values for each of a plurality of batteries measured during the battery activation process. Here, the activation process data may include one or more of temperature data, voltage data, charge capacity data, and discharge capacity data for each battery.

The prediction model generation apparatus may use the activation process data to generate a plurality of predetermined statistical values (S420). Here, the statistical values may include one or more of the following: a first quartile temperature value (a temperature value located at the 25th percentile), an average voltage value, a first quartile voltage value (a voltage value located at the 25th percentile), a third quartile voltage value (a voltage value located at the 75th percentile), a sum of charge capacities, and a sum of discharge capacities.

Thereafter, the prediction model generation apparatus may use the statistical values generated in S420 as training data to train a prediction model (S430).

The prediction model may be predefined to output a predicted battery capacity at a specific temperature upon being input statistical values.

The training data may include the plurality of statistical values generated in S420 and the actual battery capacity. For example, the training data may include a first quartile temperature value, an average voltage value, a first quartile voltage value, a third quartile voltage value, a sum of charge capacities, and a sum of discharge capacities, which are calculated using the activation process data, and may also include an actual value of the battery capacity at 40 degrees Celsius.

Once training for the prediction model is completed, the prediction model generation apparatus may transmit the trained prediction model to the battery capacity prediction apparatus.

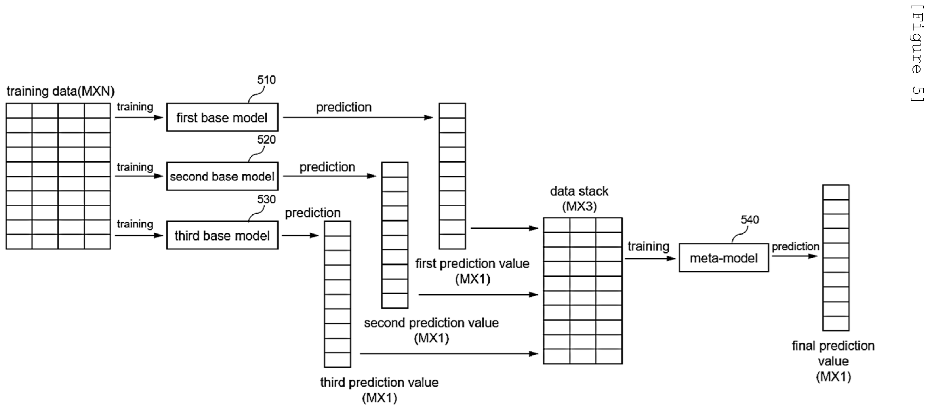

FIG. 5 is a block diagram of a prediction model according to embodiments of the present invention.

The prediction model according to embodiments of the present invention may include a plurality of base models and a metamodel. For example, as illustrated in FIG. 5, the prediction model may include three base models 510, 520, and 530 and one metamodel 540.

Each of the base models 510, 520, and 530 may be trained to output a battery capacity at a specific temperature as a predicted value when the statistical values calculated in step S420 are input as training data.

The metamodel 540 may be trained to output a battery capacity at a specific temperature as a final predicted value when the predicted values of each of the base models 510, 520, 530 are input as training data.

More specifically, the prediction model generation apparatus may train each of the first to third base models 510, 520, 530 using the statistical values produced in S420 as training data. For example, the prediction model generation apparatus may train each of the first to third base models 510, 520, 530 using one or more of the first quartile temperature value, the average voltage value, the first quartile voltage value, the third quartile voltage value, the sum of the charge capacities, and the sum of the discharge capacities as training data.

Furthermore, the prediction model generation apparatus may stack the prediction values (the first to third prediction values) output from each of the first to third base models 510, 520, 530 to create a data stack, and use the data stack as training data to train the metamodel 540. Here, the final prediction value output by the metamodel 540 may be utilized as the battery capacity at a predetermined specific temperature.

The base model may be defined based on any one of the RandomForest (RF) algorithm, the Support Vector Machine (SVM) algorithm, and the Principal Components Regression (PCR) algorithm. For example, in FIG. 5, the prediction model may include a first base model 510 based on the RF algorithm, a second base model 520 based on the SVM algorithm, and a third base model 530 based on the PCR algorithm.

Furthermore, the metamodel may be defined based on any one of the RF algorithm, the SVM algorithm, and the PCR algorithm. For example, in FIG. 5, the prediction model may include a metamodel 540 based on the SVM algorithm.

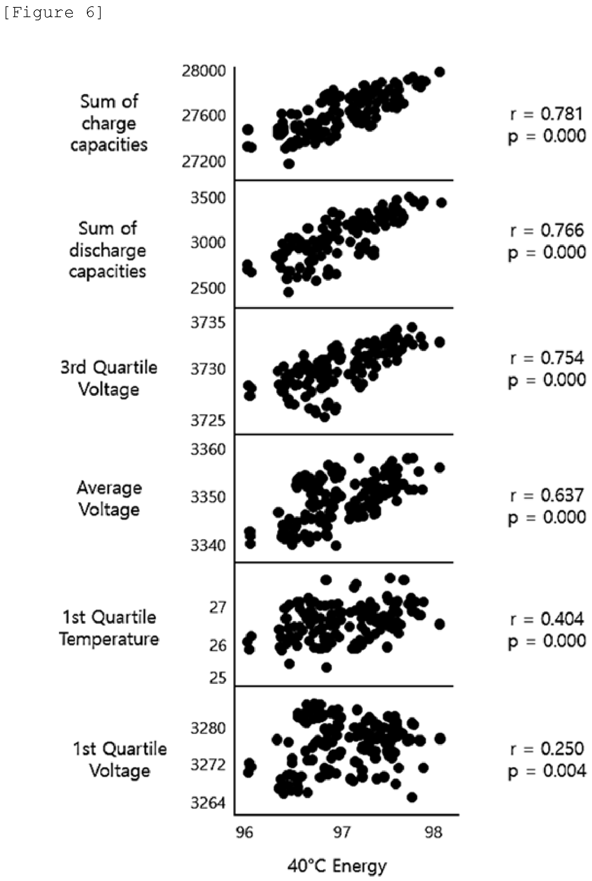

FIG. 6 is a graph illustrating the variables applied to a prediction model according to embodiments of the present invention.

To improve both the accuracy and processing speed of the prediction model, it is important to determine the optimal combination of variables to be applied. To select variables with a high correlation with a desired outcome to predict (battery capacity), a comparative test was conducted as follows.

**[Table 1]**

| No. | RMSE | Combination of statistics |
|---|---|---|
| 1 | 0.1386 | 1st quartile temperature, mean voltage, 1st quartile voltage, 3rd quartile voltage, sum of charge capacities, sum of discharge capacities |
| 2 | 0.1401 | lowest temperature, 3rd quartile temperature, lowest capacity, 1st quartile capacity, mean voltage, 1st quartile voltage |
| 3 | 0.1416 | quartile temperature, mean capacity, sum of charge capacities, lowest voltage, 1st quartile voltage, 3rd quartile voltage |
| 4 | 0.1419 | mean temperature, median temperature, capacity deviation, sum of charge capacities, median voltage, 1st quartile voltage |
| 5 | 0.1423 | 1st quartile temperature, median capacity, sum of charge capacities, sum of discharge capacities, mean voltage, 3rd quartile voltage |
| ... | ... | ... |
| 100947 | 0.3912 | average temperature, median temperature, temperature Deviation, 1st Quartile temperature, minimum Capacity, minimum voltage |

Specifically, prediction models, including a first base model based on the RF algorithm, a second base model based on the SVM algorithm, a third base model based on the PCR algorithm, and a metamodel based on the SVM algorithm, were defined. As shown in Table 1, each of 100,947 combinations of variable was applied to the prediction model, and the Root Mean Square Error (RMSE) for each variable combination was calculated. Comparative test results show that defining [1st Quartile Temperature, Average Voltage, 1st Quartile Voltage, 3rd Quartile Voltage, Sum of charge capacities, Sum of discharge capacities] as variables in the prediction model resulted in the highest prediction accuracy.

FIG. 6 shows the scatter plot matrix, Spearman correlation coefficient (r), and p-value for the battery capacity (40°C Energy) and each of the six optimal variables. Referring to FIG. 6, it can be confirmed that the six variables (1st quartile temperature value, average voltage value, 1st quartile voltage value, 3rd quartile voltage value, sum of charge capacities, and sum of discharge capacities) derived through the comparison test have a statistically significant correlation with the battery capacity.

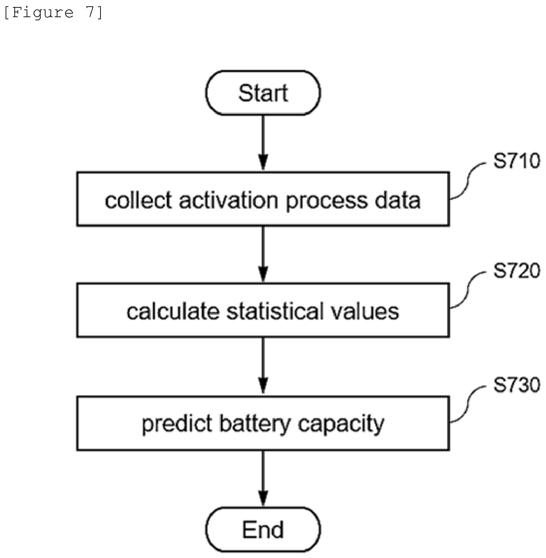

FIG. 7 is an operational flowchart of a battery capacity prediction method according to embodiments of the present invention.

The battery capacity prediction apparatus may collect activation process data (S710).

The activation process data may include state values for each of a plurality of batteries measured during the battery activation process. Here, the activation process data may include temperature data, voltage data, charge capacity data, and discharge capacity data for each battery.

The battery capacity prediction apparatus may use the activation process data to calculate a plurality of predefined statistical values (S720). Here, the statistical values may include one or more of the following: a first quartile temperature value (temperature value located at the 25th percentile), an average voltage value, a first quartile voltage value (voltage value located at the 25th percentile) , a third quartile voltage value (voltage value located at the 75th percentile), a sum of charge capacities, and a sum of discharge capacities.

Thereafter, the battery capacity prediction apparatus may input the statistical values calculated in step S720 into a pre-trained prediction model and use the predicted values output by the prediction model to predict the battery capacity at a specific temperature (step S730).

The prediction model may be pre-trained to output the battery capacity at a specific temperature as a predicted value when statistical values are input.

The prediction model may include a plurality of base models and a metamodel. For example, as illustrated in FIG. 5, the prediction model may include three base models 510, 520, and 530 and one metamodel 540.

Each of the base models may be in a state in which training has been completed to output the battery capacity at a specific temperature as a predicted value when the statistical values calculated in step S720 are input as input data.

The metamodel may be in a state in which training has been completed to output the battery capacity at a specific temperature as a final predicted value when the predicted values of each of the base models are input as input data.

More specifically, the battery capacity prediction apparatus may input the statistical values calculated in S720 into each of the first to third base models. For example, the battery capacity prediction apparatus may input the first quartile temperature value, the average voltage value, the first quartile voltage value, the third quartile voltage value, the sum of the charge capacities, and the sum of the discharge capacities into each of the first to third base models.

Thereafter, the battery capacity prediction apparatus may stack the predicted values (the first to third predicted values) output from each of the first to third base models to create a data stack and input the data stack into the metamodel. Here, the battery capacity prediction apparatus may determine the final predicted value output by the metamodel as the battery capacity at a predefined specific temperature.

The base model may be defined based on any one of the Random Forest (RF) algorithm, the Support Vector Machine (SVM) algorithm, and the Principal Components Regression (PCR) algorithm. For example, a prediction model may include a first base model based on the RF algorithm, a second base model based on the SVM algorithm, and a third base model based on the PCR algorithm.

Furthermore, the metamodel may be defined based on any one of the RF algorithm, SVM algorithm, and PCR algorithm.

To derive the optimal prediction model with the highest prediction accuracy, a comparative test was conducted as follows.

**[Table 2]**

| Model | RMSE | MAE |
|---|---|---|
| Comparative Example 1 - RF | 0.1968 | 0.1524 |
| Comparative Example 2 - SVM | 0.2125 | 0.1707 |
| Comparative Example 3 - PCR | 0.2098 | 0.1686 |
| Example 1 - Stacking RF | 0.1942 | 0.1534 |
| **Example 2 - Stacking SVM** | **0.1848** | **0.1489** |
| Example 3 - Stacking PCR | 0.1877 | 0.1501 |

Comparative Examples 1 to 3 are single prediction models. Comparative Example 1 is a model based on the RF algorithm, Comparative Example 2 is a model based on the SVM algorithm, and Comparative Example 3 is a model based on the PCR algorithm. Examples 1 to 3 are ensemble models comprising three base models (a first base model based on the RF algorithm, a second base model based on the SVM algorithm, and a third base model based on the PCR algorithm) and one metamodel.

Here, Example 1 is an ensemble model using an RF algorithm-based metamodel, Example 2 is an ensemble model using an SVM algorithm-based metamodel, and Example 3 is an ensemble model using a PCR algorithm-based metamodel.

Comparative test results confirmed that Examples 1 to 3 all exhibited higher prediction accuracy than Comparative Examples 1 to 3.

In particular, it can be confirmed that the prediction model exhibits the highest prediction accuracy when the prediction model is composed of a first base model based on the RF algorithm, a second base model based on the SVM algorithm, a third base model based on the PCR algorithm, and a metamodel based on the SVM algorithm (Example 2).

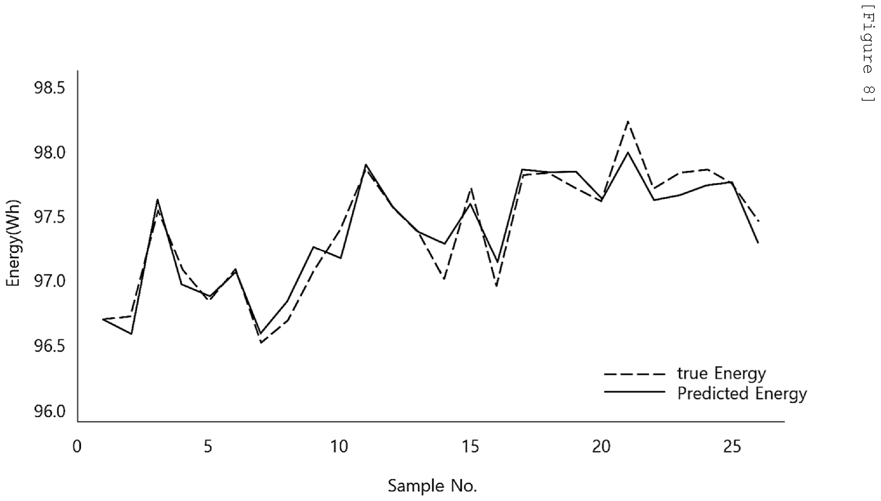

FIG. 8 is a graph illustrating the prediction accuracy of a battery capacity prediction method according to embodiments of the present invention.

Specifically, FIG. 8 is a graph comparing the results of battery capacity prediction using the prediction model according to Example 2 of [Table 2] by a battery capacity prediction apparatus with actual battery capacity (energy).

The battery capacity prediction apparatus according to embodiments of the present invention can predict battery capacity at a specific temperature with greater accuracy using activation process data and quickly produce prediction results without delaying data processing speed by using only six statistical values.

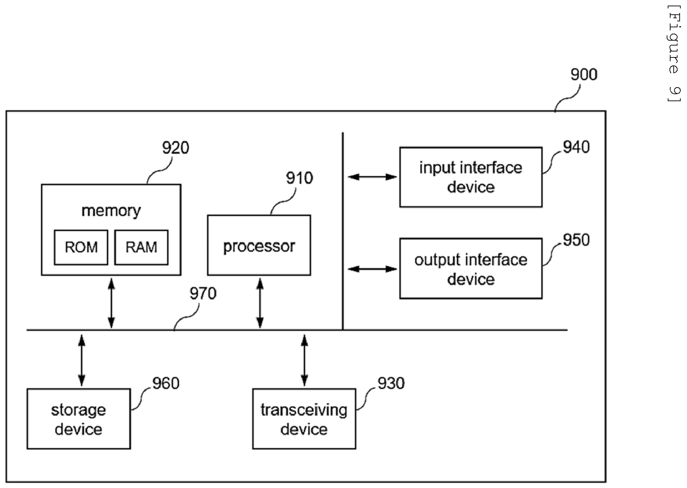

FIG. 9 is a block diagram of a prediction model generation apparatus according to embodiments of the present invention.

The prediction model generation apparatus 900 may include at least one processor 910, a memory 920 that stores at least one instruction executed by the processor, and a transceiving device 930 connected to a network for communication.

The at least one instruction may include: an instruction to collect activation process data, the activation process data including state values for each of a plurality of batteries measured during a battery activation process; an instruction to calculate a plurality of predetermined statistical values using the activation process data; and an instruction to train a machine learning-based prediction model by using the statistical values as training data to output a predicted battery capacity at a specific temperature as a predicted value.

The activation process data may include **one or more of** temperature data, voltage data, charge capacity data, and discharge capacity data for each of the batteries.

The instruction to calculate the plurality of predetermined statistical values may include an instruction to calculate a first quartile temperature value, an average voltage value, a first quartile voltage value, a third quartile voltage value, a sum of charge capacities, and a sum of discharge capacities using the activation process data.

The prediction model may include a plurality of base models that has been trained with the statistical values and output a predicted value; and a metamodel that has been trained with each of prediction values of the base models and outputs a final predicted value.

The instruction to train the prediction model may include an instruction to stack the prediction values of each of the base models when the prediction values are output, thereby creating a data stack; and an instruction to train the metamodel using the data stack as training data.

The prediction model may include a first base model based on a RandomForest (RF) algorithm, a second base model based on a Support Vector Machine (SVM) algorithm, and a third base model based on a Principal Components Regression (PCR) algorithm.

The prediction model may include any one of a first metamodel based on an RF algorithm, a second metamodel based on an SVM algorithm, and a third metamodel based on a PCR algorithm.

The at least one instruction may further include an instruction to transmit the prediction model to a battery capacity prediction device when training of the prediction model is completed.

The prediction model generation apparatus 900 may further include an input interface device 940, an output interface device 950, a storage device 960, and the like. Each component included in the prediction model generation apparatus 900 may be connected via a bus 970 to communicate with one another. The storage device 960 may store diagnostic models, defect detection models, and anomaly detection models.

Here, the processor 910 may refer to a central processing unit (CPU), a graphics processing unit (GPU), or a dedicated processor for executing methods according to embodiments of the present invention. The memory (or storage device) may be comprised of at least one of volatile storage media and non-volatile storage media. For example, the memory may be comprised of at least one of read-only memory (ROM) and random access memory (RAM).

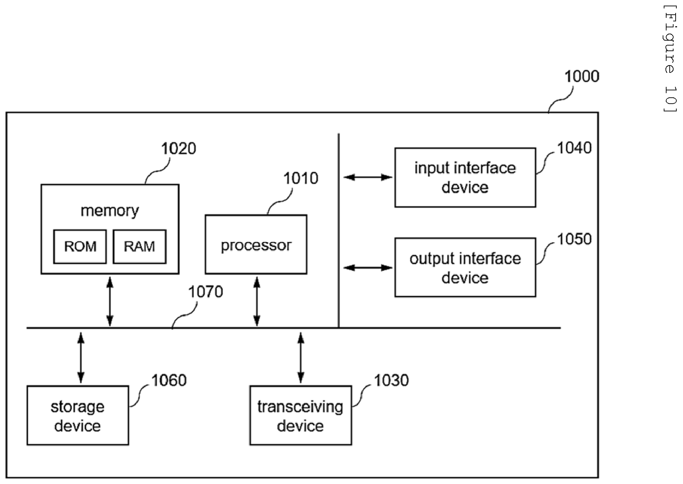

FIG. 10 is a block diagram of a battery capacity prediction apparatus according to embodiments of the present invention.

The battery capacity prediction apparatus 1000 according to embodiments of the present invention may include at least one processor 1010, a memory 1020 that stores at least one command executed by the processor, and a transceiving device 1030 that is connected to a network and performs communication.

The at least one instruction may include an instruction to collect activation process data, the activation process data including state values for each of a plurality of batteries measured during a battery activation process; an instruction to calculate a plurality of predetermined statistical values using the activation process data; and an instruction to input the statistical values into a pre-trained prediction model to predict a battery capacity at a specific temperature using the predicted values output by the prediction model.

The activation process data includes **one or more of** temperature data, voltage data, charge capacity data, and discharge capacity data for each of the batteries.

The instruction to calculate the plurality of predetermined statistical values may include an instruction to calculate a first quartile temperature value, an average voltage value, a first quartile voltage value, a third quartile voltage value, a sum of charge capacities, and a sum of discharge capacities using the activation process data.

The prediction model may include a plurality of base models that output a predicted value when the statistical values are input; and a metamodel that outputs a final predicted value when predicted values of each of the base models are input.

The instruction to predict the battery capacity may include an instruction to generate a data stack by stacking the predicted values when the predicted values of each of the base models are output; an instruction to input the data stack into the metamodel; and an instruction to determine the final predicted value output by the metamodel as the battery capacity at the specific temperature.

The prediction model may include one or more of a first base model based on a RandomForest (RF) algorithm, a second base model based on a Support Vector Machine (SVM) algorithm, and a third base model based on a Principal Components Regression (PCR) algorithm.

The prediction model may include any one of a first metamodel based on an RF algorithm, a second metamodel based on an SVM algorithm, and a third metamodel based on a PCR algorithm.

The metamodel may be a second metamodel based on an SVM algorithm.

Meanwhile, the battery capacity prediction apparatus 1000 may further include an input interface device 1040, an output interface device 1050, a storage device 1060, etc. Respective components included in the battery capacity prediction apparatus 1000 may be connected by a bus 1070 and can communicate with each other. The storage device 1060 may store diagnostic models, defect detection models, and anomaly detection models.

Here, the processor 1010 may mean a central processing unit (CPU), a graphics processing unit (GPU), or a dedicated processor on which methods according to embodiments of the present invention are performed. In addition, the memory may include at least one of a volatile/transitory storage medium and a non-volatile/non- transitory storage medium. For example, the memory may include at least one of read only memory (ROM) and random access memory (RAM), and may include electrically erasable programmable read-only Memory (EEPROM) .

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

The operations of the method according to embodiments of the present invention may be implemented in various forms related to programs, such as a computer program or code itself, or a computer program product.

Furthermore, the computer-readable recording medium may include one or more of a volatile/transitory recording medium and a non-volatile/non-transitory recording medium.

In addition, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery capacity prediction apparatus comprising:
at least one processor; and
a memory configured to store at least one instruction executed by the at least one processor,
wherein the at least one instruction includes:
an instruction to collect activation process data, the activation process data including state values for each of a plurality of batteries measured during a battery activation process;
an instruction to calculate a plurality of predetermined statistical values using the activation process data; and
an instruction to input the statistical values into a pre-trained prediction model and predict a battery capacity at a specific temperature using predicted values output by the prediction model.

2. The battery capacity prediction apparatus of claim 1, wherein the activation process data includes one or more of temperature data, voltage data, charge capacity data, and discharge capacity data for each of the batteries.

3. The battery capacity prediction apparatus of claim 1, wherein the instruction to calculate the plurality of statistical values includes:
an instruction to calculate a first quartile temperature value, an average voltage value, a first quartile voltage value, a third quartile voltage value, a sum of charge capacities, and a sum of discharge capacities using the activation process data.

4. The battery capacity prediction apparatus of claim 3, wherein the prediction model includes:
a plurality of base models each of which outputs a predicted value when the statistical values are input; and
a metamodel that outputs a final predicted value when predicted values of each of the base models are input.

5. The battery capacity prediction apparatus of claim 4, wherein the instruction to predict the battery capacity includes:
an instruction to generate a data stack by stacking the predicted values when the predicted values of each of the base models are output;
an instruction to input the data stack into the metamodel; and
an instruction to determine the final predicted value output by the metamodel as the battery capacity at the specific temperature.

6. The battery capacity prediction apparatus of claim 4, wherein the prediction model includes one or more of a first base model based on a RandomForest RF algorithm, a second base model based on a Support Vector Machine SVM algorithm, and a third base model based on a Principal Components Regression PCR algorithm.

7. The battery capacity prediction apparatus of claim 6, wherein the prediction model includes any one of a first metamodel based on an RF algorithm, a second metamodel based on an SVM algorithm, and a third metamodel based on a PCR algorithm.

8. The battery capacity prediction apparatus of claim 7, wherein the metamodel is the second metamodel based on an SVM algorithm.

9. A battery capacity prediction method comprising:
collecting activation process data, the activation process data including state values for each of a plurality of batteries measured during a battery activation process;
calculating a plurality of predetermined statistical values using the activation process data; and
inputting the statistical values into a pre-trained prediction model, andpredicting a battery capacity at a specific temperature using predicted values output by the prediction model.

10. The battery capacity prediction method of claim 9, wherein the activation process data includes one or more of temperature data, voltage data, charge capacity data, and discharge capacity data for each of the batteries.

11. The battery capacity prediction method of claim 9, wherein the calculating of the plurality of statistical values includes:
calculating a first quartile temperature value, an average voltage value, a first quartile voltage value, a third quartile voltage value, a sum of charge capacities, and a sum of discharge capacities using the activation process data.

12. The battery capacity prediction method of claim 11, wherein the prediction model includes:
a plurality of base models each of which outputs a predicted value when the statistical values are input; and
a metamodel that outputs a final predicted value when predicted values of each of the base models are input.

13. The battery capacity prediction method of claim 12, wherein the predicting of the battery capacity includes:
generating a data stack by stacking the predicted values when the predicted values of each of the base models are output;
inputting the data stack into the metamodel; and
determining the final predicted value output by the metamodel as the battery capacity at the specific temperature.

14. A battery capacity prediction system comprising:
a battery capacity prediction apparatus that predicts battery capacity at a specific temperature using a machine learning-based prediction model; and
a prediction model generation apparatus that generates the prediction model and provides the prediction model to the battery capacity prediction apparatus,
wherein the prediction model generation apparatus uses battery activation process data to calculate a plurality of predetermined statistical values and uses the statistical values as training data to train the prediction model.
